# EUROPEAN PATENT APPLICATION

(11) **EP 4 672 683 A1**
(43) Date of publication of application: **31.12.2025**
(21) Application number: 25184977.4
(22) Date of filing: 24.06.2025
(51) Int. Cl.: H04L 25/02, G06F 13/40

(54) **TRANSMISSION DRIVER INTEGRATED CIRCUIT, DEVICE INCLUDING THE SAME, AND BUS SYSTEM**

(30) Priority: 25.06.2024 JP 2024102146
(71) Applicant: Mitsumi Electric Co., Ltd., Tama-Shi, Tokyo 206-8567 (JP)
(72) Inventor: YOSHIKUNI, Masato, TAMA-SHI, 206-8567 (JP); TOMITA, Daisuke, TAMA-SHI, 206-8567 (JP)
(74) Representative: Regimbeau

(57) **Abstract**

A bus system includes a first transmission driver IC, a second transmission driver IC, a first communication line and a second communication line that couple the first transmission driver IC and the second transmission driver IC, and a termination resistor coupled between the first communication line and the second communication line. Each of the first transmission driver IC and the second transmission driver IC includes a transmission circuit configured to transmit a differential signal to the first communication line and the second communication line, a reception circuit configured to convert the differential signal that is received from the first communication line and the second communication line to an internal signal, a bypass circuit coupled to the first communication line or the second communication line, and a control circuit configured to operate the bypass circuit using the internal signal as a trigger such that a communication line current flowing into the first communication line or the second communication line flows into the bypass circuit.

## Description

### TECHNICAL FIELD

The present disclosure relates to a transmission driver IC, a device including the transmission driver IC, and a bus system.

### BACKGROUND

Conventionally, a bus system that transmits a differential signal through a pair of lines is known (see, for example, Patent Document 1).

### RELATED-ART DOCUMENTS

### PATENT DOCUMENTS

Patent Document 1: Japanese Unexamined Patent Application Publication No. 2014-107660

### SUMMARY

In conventional bus systems that transmit differential signals through pairs of lines, when impedance matching is not achieved between signal transmission and reception, currents (communication line currents) generated in the pairs of lines due to communication delays or reflection, flow into termination resistors connected between the pairs of lines. When the communication line currents flow into the termination resistors, voltages are each generated across ends of a termination resistor, and a communication waveform propagated by each pair of lines may be distorted. The distortion of the communication waveform may cause a communication failure.

An object of the present disclosure is to suppress the distortion of the communication waveform.

The present disclosure provides a bus system including:
a first transmission driver IC;
a second transmission driver IC;
a first communication line and a second communication line that couple the first transmission driver IC and the second transmission driver IC; and
a termination resistor coupled between the first communication line and the second communication line,
wherein each of the first transmission driver IC and the second transmission driver IC includes:
   a transmission circuit configured to transmit a differential signal to the first communication line and the second communication line,
   a reception circuit configured to convert the differential signal that is received from the first communication line and the second communication line to an internal signal,
   a bypass circuit coupled to the first communication line or the second communication line, and
   a control circuit configured to operate the bypass circuit using the internal signal as a trigger such that a communication line current flowing into the first communication line or the second communication line flows into the bypass circuit.

The present disclosure provides a transmission driver IC including:
a transmission circuit configured to transmit a differential signal to a first communication line and a second communication line between which a termination resistor is interposed;
a reception circuit configured to convert the differential signal that is received from the first communication line and the second communication line to an internal signal;
a bypass circuit; and
a control circuit configured to operate the bypass circuit using the internal signal as a trigger such that a communication line current flowing into the first communication line or the second communication line flows into the bypass circuit, which is coupled to the first communication line or the second communication line.

The present disclosure provides a device including:
an input/output circuit configured to output a transmission signal and receive a reception signal; and
a transmission driver IC including:
   a transmission circuit configured to convert the transmission signal to a differential signal to be transmitted to a first communication line and a second communication line between which a termination resistor is interposed,
   a reception circuit configured to convert the differential signal that is received from the first communication line and the second communication line to an internal signal,
   a bypass circuit, and
   a control circuit configured to operate the bypass circuit by using the internal signal as a trigger such that a communication line current flowing into the first communication line or the second communication line flows into the bypass circuit, which is coupled to the first communication line or the second communication line.

### EFFECT OF INVENTION

In the present disclosure, distortion of communication waveforms can be suppressed.

### BRIEF DESCRIPTION OF THE DRAWINGS

[FIG. 1] FIG. 1 is a diagram illustrating a bus system to which transmission driver ICs of the present disclosure can be applied.
[FIG. 2] FIG. 2 is a timing chart illustrating waveforms of each part of the bus system.
[FIG. 3] FIG. 3 is a diagram illustrating a bus system including transmission driver ICs in a first comparative example.
[FIG. 4] FIG. 4 is a diagram illustrating waveforms of each part of the bus system including the transmission driver IC in the first comparative example.
[FIG. 5] FIG. 5 is a diagram illustrating a bus system including transmission driver ICs according to a first embodiment.
[FIG. 6] FIG. 6 is a diagram illustrating waveforms of each part of the bus system including the transmission driver ICs according to the first embodiment.
[FIG. 7] FIG. 7 is a timing chart for describing an example of a configuration and method for controlling a bypass circuit by the transmission driver ICs according to the first embodiment.
[FIG. 8] FIG. 8 is a diagram illustrating a bus system including transmission driver ICs according to a second embodiment.
[FIG. 9] FIG. 9 is a timing chart for describing an example of a configuration and a method for controlling the bypass circuits by the transmission driver ICs according to the second embodiment.
[FIG. 10] FIG. 10 is a diagram illustrating a bus system including transmission driver ICs according to a third embodiment.
[FIG. 11] FIG. 11 is a diagram showing an example of the effect of suppressing distortion of the waveform of an AMI signal at a communication speed of 9.6 kbps.
[FIG. 12] FIG. 12 is a diagram showing an example of the effect of suppressing the distortion of the waveform of the AMI signal at a communication speed of 300 kbps.

### DETAILED DESCRIPTION

Embodiments of the present disclosure will be described below with reference to the drawings.

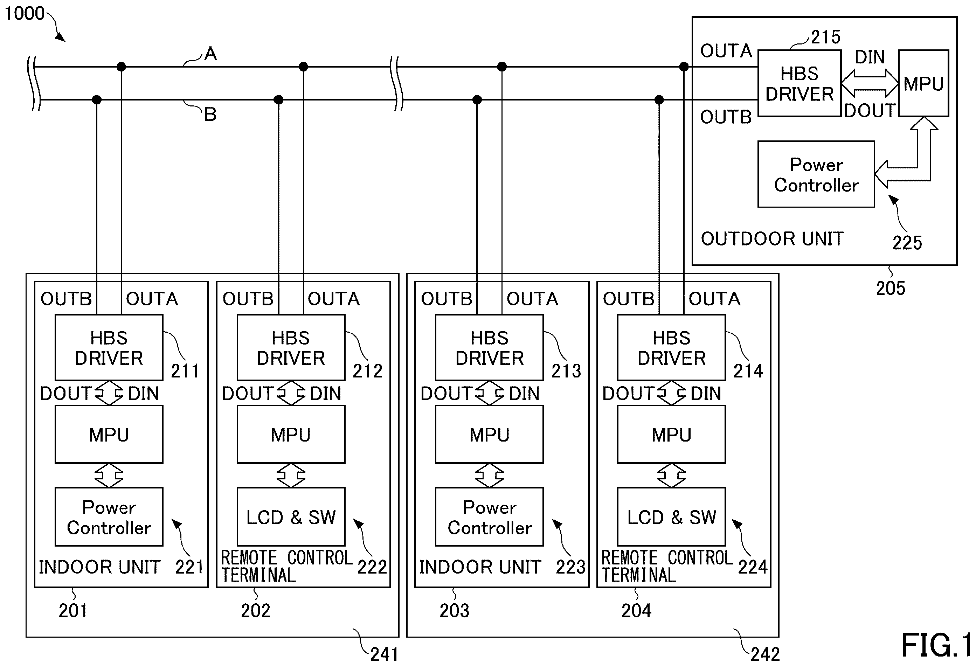

FIG. 1 is a diagram illustrating a bus system to which transmission driver ICs of the present disclosure can be applied. A bus system 1000 shown in FIG. 1 is a communication system including a plurality of transmission driver ICs (Integrated Circuits) that are balanced-connected to one another via a pair of communication lines A and B. FIG. 1 illustrates 5 drivers 211, 212, 213, 214, and 215 (hereinafter may also be referred to as "driver 211 and the like") as the plurality of transmission driver ICs. The driver 211 and the like are circuits that have the same communication interface circuits, and that communicate with one another via a differential signal transmitted on the pair of communication lines A and B.

FIG. 1 illustrates a case where the bus system 1000 is applied to communications among air conditioning devices. The bus system 1000 has a plurality of air conditioning devices that are balanced-connected to one another via the pair of communication lines A and B. FIG. 1 illustrates the plurality of air conditioning devices that include an indoor unit 201, a remote control terminal 202, an indoor unit 203, a remote control terminal 204, and an outdoor unit 205.

The indoor unit 201 has a driver 211 and an input/output circuit 221, and performs air conditioning of a room 241. The remote control terminal 202 has a driver 212 and an input/output circuit 222, and is an operating terminal for performing remote control operations of the indoor unit 201. The indoor unit 203 has a driver 213 and an input/output circuit 223, and performs air conditioning of a room 242. The remote control terminal 204 has a driver 214 and an input/output circuit 224, and is an operating terminal for performing remote control operations of the indoor unit 203. The outdoor unit 205 has a driver 215 and an input/output circuit 225, and discharges air that has exchanged heat with refrigerant that circulates between the indoor units 201 and 203 and the outdoor unit 205 to the outdoors.

Specific examples of the input/output circuits 221 and 223 include processors such as MPUs (Micro Processing Units), or power controllers that control air-conditioning operations of the indoor units 201 and 203. Specific examples of the input/output circuit 222 and 224 include MPUs, display devices such as LCDs (Liquid Crystal Displays), switches (SWs), or the like. A specific example of the input/output circuit 225 includes an MPU or a power controller that controls refrigerant compression operations of the outdoor unit 205.

The driver 211 and the like conform to a home bus system (HBS), but may conform to a bus system different from the HBS. The driver 211 and the like include transmit terminals OUTA that are connected to the communication line A through one or more capacitors (not shown), and include transmit terminals OUTB that are connected to the communication line B through one or more capacitors (not shown).

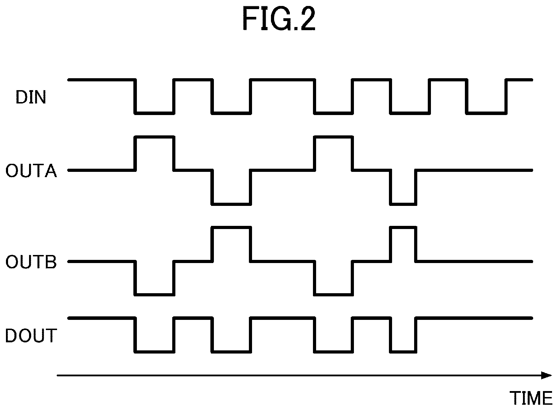

FIG. 2 is a timing chart illustrating waveforms of each part of the bus system. The bus system 1000 adopts, for example, an AMI (Alternate Mark Inversion) scheme for waveforms of signals that are transmitted among a plurality of devices. The driver 211 and the like have transmission circuits each of which converts a square wave signal received at an input terminal DIN from a microcomputer such as an MPU, to a pair of differential AMI signals, and each of which then transmits these signals from the transmit terminals OUTA and OUTB. The driver 211 and the like have reception circuits each of which converts the pair of differential AMI signals received via the pair of communication lines A and B to square wave signals and each of which then transmits these signals to a microcomputer such as an MPU, via the output terminal DOUT. An AMI signal propagating on the communication line A, and an AMI signal propagating on the communication line B are in opposite phases to each other.

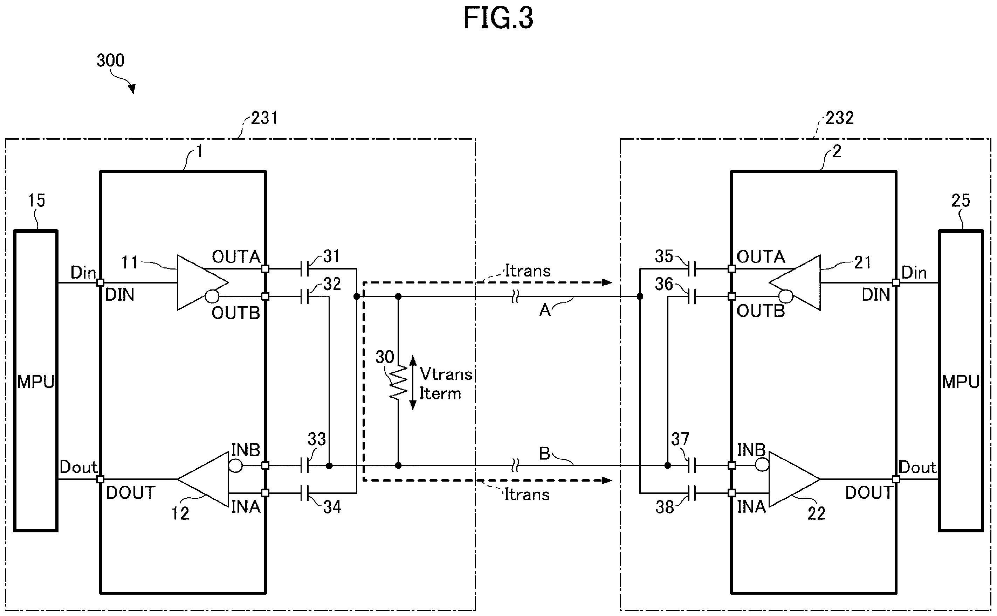

FIG. 3 is a diagram illustrating the bus system including transmission driver ICs in a first comparative example. A bus system 300 shown in FIG. 3 is a communication system that transmits and receives a differential signal between a plurality of devices. For simplicity of explanation, FIG. 3 illustrates two devices 231 and 232 connected to each other by a pair of communication lines A and B. The bus system 300 includes the device 231, the device 232, the communication line A, and the communication line B. The device 231 includes an MPU 15, a transmission driver IC 1, capacitors 31, 32, 33, and 34, and a termination resistor 30. The termination resistor 30 is connected between the communication line A and the communication line B. The device 232 includes an MPU 25, a transmission driver IC 2, and capacitors 35, 36, 37, and 38.

The transmission driver IC 1 includes a transmission circuit 11 and a reception circuit 12. The transmission circuit 11 converts a square wave signal Din from the MPU 15 received at an input terminal DIN to a pair of differential AMI signals, and transmits these signals to communication lines A and B from transmit terminals OUTA and OUTB. The transmit terminal OUTA is electrically connected to the communication line A through the capacitor 31. The transmit terminal OUTB is electrically connected to the communication line B through the capacitor 32. The reception circuit 12 converts the pair of differential AMI signals that are received at receive terminals INA and INB via the communication lines A and B, to a square wave signal Dout, and transmits the square wave signal Dout to the MPU 15 from an output terminal DOUT. The receive terminal INA is electrically connected to the communication line A through the capacitor 34. The receive terminal INB is electrically connected to the communication line B through the capacitor 33.

The transmission driver IC 2 includes a transmission circuit 21 and a reception circuit 22. The transmission circuit 21 converts a square wave signal Din from the MPU 25 received at an input terminal DIN to a pair of differential AMI signals, and transmits these signals to the communication lines A and B from transmit terminals OUTA and OUTB. The transmit terminal OUTA is electrically connected to the communication line A through the capacitor 35. The transmit terminal OUTB is electrically connected to the communication line B through the capacitor 36. The reception circuit 22 converts the pair of differential AMI signals that are received at receive terminals INA and INB via the pair of communication lines A and B, to a square wave signal Dout, and transmits the square wave signal Dout to the MPU 25 from an output terminal DOUT. The receive terminal INA is electrically connected to the communication line A through the capacitor 38. The receive terminal INB is electrically connected to the communication line B through the capacitor 37.

In the bus system 300, the termination resistor 30 is provided in the device 231, but no termination resistor is provided in the device 232. In this case, as the communication lines A and B between the device 231 and the device 232 become longer, it becomes increasingly difficult to achieve impedance matching between the device 231 and the device 232. If impedance matching between the device 231 and the device 232 is not achieved, part or all of a current (communication line current Itrans) generated in the pair of communication lines A and B due to communication delay, reflection, or the like flows into the termination resistor 30 as current Iterm. If the communication line current Itrans flows into the termination resistor 30, a voltage Vtrans is generated across ends of the termination resistor 30, and a communication waveform propagated by the pair of communication lines A and B might be distorted. The distortion of the communication waveform might cause a communication failure.

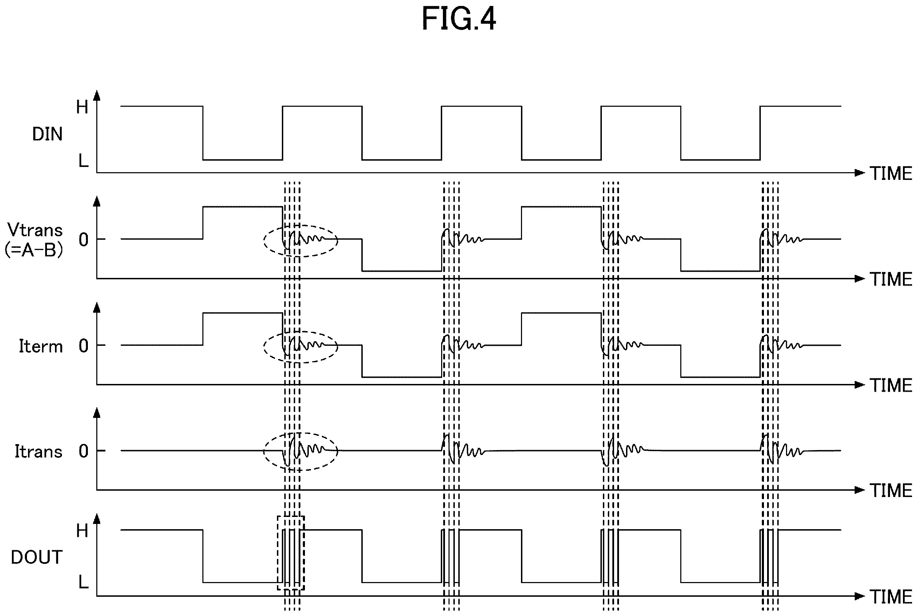

FIG. 4 is a diagram illustrating waveforms of each part of the bus system including the transmission driver IC in the first comparative example. "H" means high level, whereas "L" means low level (the same applies to the waveforms in the other drawings).

The transmission circuit 11 converts the square wave signal Din from the MPU 15 received at the input terminal DIN to the pair of differential AMI signals, and transmits these signals to the communication lines A and B from the transmit terminals OUTA and OUTB. The voltage Vtrans is a voltage generated across the ends of the termination resistor 30, and is a differential voltage obtained by subtracting the potential of the communication line B from the potential of the communication line A.

If the impedance matching is not achieved between the device 231 and the device 232, the communication line current Itrans due to communication delay, reflection, or the like flows into the pair of communication lines A and B. Part or all of the communication line current Itrans flows into the termination resistor 30 as the current Iterm. As the current Iterm fluctuates, the voltage Vtrans rings, and the communication waveform (in this case, the voltage Vtrans) propagated by the pair of communication lines A and B might be distorted. The ringing of the communication waveform might cause chattering of a reception signal Dout output from the reception circuit 22 to the MPU 25 via the output terminal DOUT, which might cause poor reception in the MPU 25. If the communication waveform distorts due to excessive current Iterm that flows into the termination resistor 30, communications between the device 231 and the device 232 might become unstable.

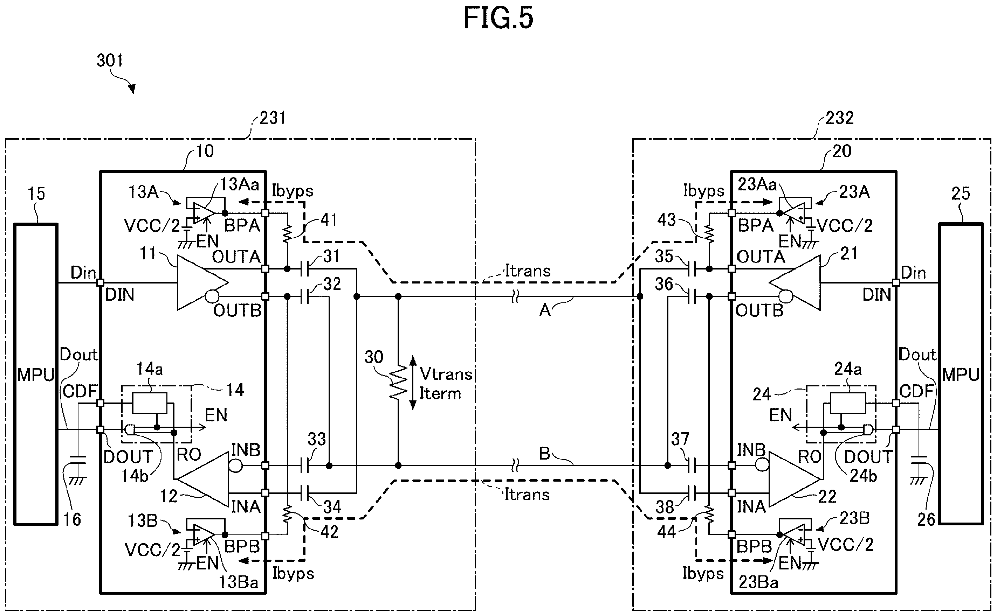

On the other hand, a bus system 301 according to a first embodiment shown in FIG. 5 suppresses the distortion of the communication waveform by reducing excess current Iterm that flows into the termination resistor 30. Hereinafter, the bus system 301 according to the first embodiment will be described.

FIG. 5 is a diagram illustrating the bus system including transmission driver ICs according to the first embodiment. A bus system 301 shown in FIG. 5 is a communication system that transmits and receives a differential signal between a plurality of devices. For simplicity of explanation, FIG. 5 illustrates two devices 231 and 232 connected to each other by a pair of communication lines A and B. The number of devices connected to the pair of communication lines A and B is not limited to two, and may be three or more. Each of the devices 231 and 232 may be, for example, any one of the above air-conditioning devices.

In FIG. 5, the bus system 301 includes the device 231, the device 232, the communication line A, and the communication line B. The device 231 include the MPU 15, a transmission driver IC 10, capacitors 31, 32, 33, and 34, and a termination resistor 30. The termination resistor 30 is connected between the communication lines A and B. The device 232 includes an MPU 25, a transmission driver IC 20, and capacitors 35, 36, 37 and 38.

The termination resistor 30 is a resistor interposed between the communication line A and the communication line B. In the illustrated example, the termination resistor 30 is provided only in the device 231, but may be provided only in the device 232 or in both of the devices 231 and 232. Even in a case where the termination resistor 30 is provided in both of the devices 231 and 232, the longer the communication lines A and B, the impedance matching between the device 231 and the device 232 may not be achieved due to the impedance or the like of the communication lines A and B. If the termination resistor 30 is electrically connected between the communication lines A and B, the termination resistor 30 may be built in one or both of the transmission driver ICs 10 and 20, or the termination resistor 30 may be provided outside the devices 231 and 232.

The MPUs 15 and 25 are examples of input/output circuits that output transmission signals and receive reception signals. Each of the MPUs 15 and 25 may be any of the above-described input/output circuits that are provided in the above air-conditioning devices. The MPU 15 outputs a square wave signal Din as a transmission signal to the transmission driver IC 10, and receives a square wave signal Dout as a reception signal from the transmission driver IC 10. The MPU 25 outputs a square wave signal Din as a transmission signal to the transmission driver IC 20, and receives a square wave signal Dout as a reception signal from the transmission driver IC 20.

The transmission driver IC 10 is an example of a first transmission driver IC. The transmission driver IC 10 is a semiconductor integrated circuit including the transmission circuit 11, the reception circuit 12, bypass circuits 13A and 13B, and a control circuit 14. In this example, the transmission driver IC 10 further includes a plurality of terminals including a transmit terminal OUTA, a transmit terminal OUTB, a receive terminal INA, and a receive terminal INB. The transmit terminal OUTA is an example of a first transmit terminal. The transmit terminal OUTB is an example of a second transmit terminal. The receive terminal INA is an example of a first receive terminal. The receive terminal INB is an example of a second receive terminal.

The transmission circuit 11 converts the square wave signal Din from the MPU 15 received at the input terminal DIN to a pair of differential AMI signals, and transmits these signals to the communication lines A and B from the transmit terminals OUTA and OUTB. The transmit terminal OUTA is electrically connected to the communication line A through the capacitor 31. The transmit terminal OUTB is electrically connected to the communication line B through the capacitor 32.

The reception circuit 12 converts the pair of differential AMI signals that are received from the pair of communication lines A and B via the receive terminals INA and INB, to an internal signal RO, and outputs the internal signal RO to the control circuit 14. The receive terminal INA is electrically connected to the communication line A through the capacitor 34. The receive terminal INB is electrically connected to the communication line B through the capacitor 33.

The communication lines A and B connect the transmission driver IC 10 and the transmission driver IC 20. The communication line A is an example of a first communication line. The communication line A is connected to the transmit terminal OUTA through the capacitor 31, and to the receive terminal INA through the capacitor 34. The communication line B is an example of a second communication line. The communication line B is connected to the transmit terminal OUTB through the capacitor 32 and to receive terminal INB through the capacitor 33.

By combining capacitors 31 and 34 into one capacitor, the transmit terminal OUTA and the receive terminal INA may be combined into one transmit/receive terminal. The one transmit/receive terminal branches and connects to the transmission circuit 11 and reception circuit 12 in the transmission driver IC 10. Similarly, by combining capacitors 32 and 33 into one capacitor, the transmit terminal OUTB and the receive terminal INB may be combined into one transmit/receive terminal. The one transmit/receive terminal branches and connects to the transmission circuit 11 and the reception circuit 12 in the transmission driver IC 10.

A bypass circuit 13A is connected to the communication line A. In this example, the transmission driver IC 10 has a bypass terminal BPA, and the bypass circuit 13A is electrically connected to the communication line A via the bypass terminal BPA. The bypass circuit 13A has current sinking capability and current sourcing capability via the bypass terminal BPA. In a case of FIG. 5, the bypass circuit 13A has a buffer 13Aa having the current sinking capability and the current sourcing capability. The buffer 13Aa has an output terminal connected to the bypass terminal BPA, an inverting input terminal to which the output terminal is connected, and a non-inverting input terminal to which a constant voltage (VCC/2) is applied. VCC is a power supply voltage of the transmission driver IC 10.

A bypass circuit 13B is connected to the communication line B. In this example, the transmission driver IC 10 has a bypass terminal BPB, and the bypass circuit 13B is electrically connected to the communication line B via the bypass terminal BPB. The bypass circuit 13B has current sinking capability and current sourcing capability through the bypass terminal BPB. In the case of FIG. 5, the bypass circuit 13B has a buffer 13Ba having the current sinking capability and the current sourcing capability. The buffer 13Ba has an output terminal connected to the bypass terminal BPB, an inverting input terminal connected to the output terminal, and a non-inverting input terminal to which a constant voltage (VCC/2) is applied.

The control circuit 14 operates the bypass circuit 13A using the internal signal RO, as a trigger, that is output from the reception circuit 12 such that the communication line current Itrans flowing through the communication line A flows through the bypass circuit 13A. Similarly, the control circuit 14 operates the bypass circuit 13B using the internal signal RO, as a trigger, that is output from the reception circuit 12 such that the communication line current Itrans flowing through the communication line B flows through the bypass circuit 13B. The control circuit 14 outputs an enable signal EN to operate the bypass circuits 13A and 13B.

In this example, the enable signal EN generated by the control circuit 14 is input to the buffers 13Aa and 13Ba. The buffers 13Aa and 13Ba output (VCC/2) when the enable signal EN is active, and provide high impedance when the enable signal EN is inactive.

For example, the control circuit 14 has a signal generation circuit 14a that activates the enable signal EN by using the internal signal RO as the trigger. The signal generation circuit 14a may determine a time for activating the enable signal EN based on a charging time for the capacitor 16 connected via a connection terminal CDF of the transmission driver IC 10 to reach a predetermined first voltage. The control circuit 14 includes a logic circuit 14b that outputs a logical AND of the enable signal EN and the internal signal RO. The logic circuit 14b generates a reception signal Dout to be output to the MPU 15, based on the logical AND.

The transmission driver IC 20 is an example of a second transmission driver IC. The transmission driver IC 20 is a semiconductor integrated circuit including a transmission circuit 21, a reception circuit 22, bypass circuits 23A and 23B, and a control circuit 24. Since the transmission driver IC 20 has the same configuration and operation as the transmission driver IC 10, description thereof will be simplified by referring to the above description.

The transmission circuit 21 converts the square wave signal Din from the MPU 25 received at the input terminal DIN to a pair of differential AMI signals, and transmits these signals to the communication lines A and B from the transmit terminals OUTA and OUTB. The reception circuit 22 converts the pair of differential AMI signals that are received from the pair of communication lines A and B through the receive terminals INA and INB, to an internal signal RO, and outputs the internal signal RO to the control circuit 24. The bypass circuit 23A has current sinking capability and current sourcing capability through the bypass terminal BPA. In the case of FIG. 5, the bypass circuit 23A has a buffer 23Aa having the current sinking capability and the current sourcing capability. The bypass circuit 23B has current sinking capability and current sourcing capability via the bypass terminal BPB. In the case of FIG. 5, the bypass circuit 23B has a buffer 23Ba having the current sinking capability and the current sourcing capability.

The control circuit 24 operates the bypass circuit 23A by using the internal signal RO, as the trigger, that is output from the reception circuit 22 such that the communication line current Itrans flowing through the communication line A flows through the bypass circuit 23A. Similarly, the control circuit 24 operates the bypass circuit 23B by using the internal signal RO, as the trigger, that is output from the reception circuit 22 such that the communication line current Itrans flowing through the communication line B flows through the bypass circuit 23B. The control circuit 24 outputs an enable signal EN to operate the bypass circuits 23A and 23B.

In this example, the enable signal EN generated by the control circuit 24 is input to the buffers 23Aa and 23Ba. The buffers 23Aa and 23Ba output (VCC/2) when the enable signal EN is active, and provide high impedance when the enable signal EN is inactive.

For example, the control circuit 24 includes a signal generation circuit 24a that activates the enable signal EN by using the internal signal RO as the trigger. The signal generation circuit 24a may determine the time for activating the enable signal EN based on a charging time for the capacitor 26 connected via a connection terminal CDF of the transmission driver IC 20 to reach a predetermined first voltage. The control circuit 24 includes a logic circuit 24b that outputs the logical AND of the enable signal EN and the internal signal RO. The logic circuit 24b generates the reception signal Dout to be output to the MPU 25, based on the logical AND.

The control circuit 14 operates the bypass circuits 13A and 13B by using the internal signal RO, as the trigger, that is output from the reception circuit 12 such that the communication line current Itrans flowing through the communication lines A and B flows through the bypass circuits 13A and 13B. Similarly, the control circuit 24 operates the bypass circuits 23A and 23B by using the internal signal RO, as the trigger, that is output from the reception circuit 22 such that the communication line current Itrans flowing through the communication lines A and B flows through the bypass circuits 23 A and 23B.

The control circuit 14 operates the bypass circuits 13A and 13B as described above, and the control circuit 24 operates the bypass circuits 23A and 23B as described above. As a result, part or all of excess communication line current Itrans, which is generated due to impedance mismatch between the device 231 and the device 232, does not flow into the termination resistor 30, but the resulting current flows into the bypass circuits 13A, 13B, 23A, and 23B. Since bypass currents Ibyps flow into the bypass circuits 13A, 13B, 23A, and 23B, the excess current Iterm flowing into the termination resistor 30 is reduced, and the excess voltage Vtrans generated across the ends of the termination resistor 30 is reduced. In this arrangement, since the distortion of the communication waveform that is propagated by the pair of communication lines A and B is suppressed, the occurrence of communication failure is reduced.

In the example of FIG. 5, the bypass current Ibyps flowing into the bypass circuit 13A flows bidirectionally in a bypass path through the capacitor 31, a resistance element 41, the bypass terminal BPA, and the buffer 13Aa. The bypass current Ibyps flowing into the bypass circuit 13B flows bidirectionally in a bypass path through the capacitor 32, a resistance element 42, the bypass terminal BPB, and the buffer 13Ba. The bypass current Ibyps flowing into the bypass circuit 23A flows bidirectionally in a bypass path through the capacitor 35, a resistance element 43, the bypass terminal BPA, and the buffer 23Aa. The bypass current Ibyps flowing into the bypass circuit 23B flows bidirectionally in a bypass path through the capacitor 36, a resistance element 44, the bypass terminal BPB, and the buffer 23Ba.

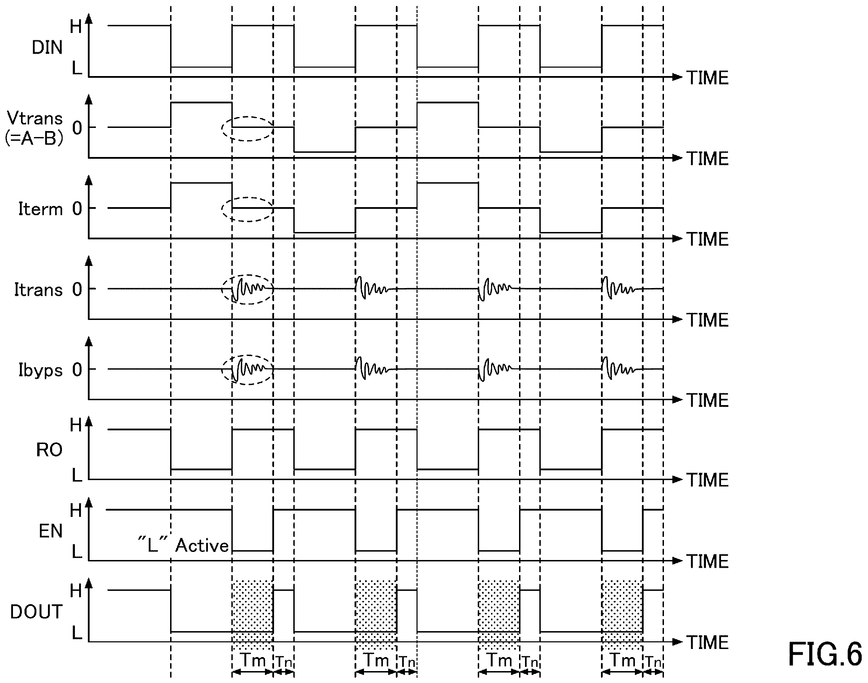

FIG. 6 is a diagram illustrating waveforms of each part of the bus system including the transmission driver IC according to the first embodiment. The transmission circuit 11 converts the square wave signal Din from the MPU 15 received at the input terminal DIN to a pair of differential AMI signals, and transmits these signals from the transmit terminals OUTA and OUTB to the communication lines A and B. The voltage Vtrans is a voltage generated across the ends of the termination resistor 30, and is a difference voltage obtained by subtracting the potential of the communication line B from the potential of the communication line A.

When the impedance matching is not achieved between the device 231 and the device 232, the communication line current Itrans due to communication delay, reflection, or the like flows in the pair of communication lines A and B. The control circuit 14 activates the enable signal EN to operate the bypass circuits 13A and 13B by using, as a trigger, a rising or falling edge of the internal signal RO that is generated by the reception circuit 12, such that the communication line current Itrans flows into the bypass circuits 13A and 13B. Similarly, the control circuit 24 activates the enable signal EN to operate the bypass circuits 23A and 23B by using, as a trigger, a rising or falling edge of the internal signal RO that is generated by the reception circuit 22, such that the communication line current Itrans flows into the bypass circuits 23A and 23B. The bypass currents Ibyps flow into the bypass circuits 13A, 13B, 23A, and 23B, and thus excess current Iterm flowing into the termination resistor 30 is reduced such that the excess voltage Vtrans generated across the ends of the termination resistor 30 is reduced. As a result, since distortion of the communication waveform propagated by the pair of communication lines A and B is suppressed, the occurrence of communication failure is reduced.

As shown in FIG. 6, the control circuit 14 supplies the communication line current Itrans into the bypass circuits 13A and 13B during an off period of a differential signal transmitted via the communication lines A and B (in this example, a period during which a voltage (corresponding to the voltage Vtrans in Fig. 6) of the AMI signal is zero). Similarly, as shown in FIG. 6, the control circuit 24 supplies the communication line current Itrans into the bypass circuits 23A and 23B during the off period of the differential signal transmitted via the communication lines A and B. This improves the accuracy of a timing that suppresses the distortion of the communication waveform occurring during the off period of the differential signal.

As shown in FIG. 6, the control circuit 14 supplies the communication line current Itrans into the bypass circuits 13A and 13B during a first half period Tm of the off period, and stops the flow of the communication line current Itrans into the bypass circuits 13A and 13B during a second half period Tn of the off period. Similarly, as shown in FIG. 6, the control circuit 24 supplies the communication line current Itrans into the bypass circuits 23A and 23B during the first half period Tm of the off period, and stops the flow of the communication line current Itrans into the bypass circuits 23A and 23B during the second half period Tn of the off period. This improves the accuracy of a timing that suppresses the distortion of the communication waveform occurring during the first half period Tm of the off period.

As shown in FIG. 6, the control circuit 14 masks an external output of the internal signal RO during the first half period Tm, and cancels the masking of the external output of the internal signal RO during the second half period Tn. In this arrangement, during the first half period Tm, the control circuit 14 does not transmit the internal signal RO as a reception signal Dout to the MPU 15 via the output terminal DOUT, but transmits the internal signal RO as the reception signal Dout to the MPU 15 via the output terminal DOUT, during the second half period Tn. As a result, even if the distortion of the internal signal RO occurs during the first half period Tm, distortion of the internal signal RO does not affect the reception signal Dout, and thus reception errors in the MPU 15 are reduced. The control circuit 24 also operates in the same manner as the control circuit 14, thereby reducing reception errors in the MPU 25.

In FIG. 5, for example, the bypass circuit 13A has a lower impedance (for example, a resistance value less than or equal to 10% of that of the termination resistor 30) than the termination resistor 30. As a result, excess communication line current Itrans caused by the impedance mismatch flows more easily into the bypass circuit 13A than into the termination resistor 30, so that the bypass current Ibyps flowing into the bypass circuit 13A increases. As a result, the effect of suppressing waveform distortion is enhanced. Similarly to the bypass circuit 13A, the bypass circuits 13B, 23A, and 23B each have a lower impedance (for example, a resistance value less than or equal to 10% of that of the termination resistor 30) than the termination resistor 30. Thus, the effect of suppressing waveform distortion is enhanced.

In FIG. 5, the bypass circuit 13A may have the resistance element 41 (for example, the resistance element 41 having a resistance value of 10% or less of that of the termination resistor 30) having a lower resistance value than the termination resistor 30. The resistance element 41 functions as an auxiliary termination resistor. By changing the resistance value of the resistance element 41, impedance matching between the device 231 and the device 232 can be finely adjusted. As in the bypass circuit 13A, the bypass circuits 13B, 23A, and 23B may have respective resistance elements 42, 43, and 44 (for example, the resistance elements 42, 43, and 44 each of which has a resistance value equal to or less than 10% of that of the termination resistor 30) whose resistance values are lower than the termination resistor 30. By changing one or more resistance values of part or all of the resistance elements 41, 42, 43, and 44, impedance matching between the device 231 and the device 232 can be finely adjusted.

The resistance element 41 may be provided outside the transmission driver IC 10. In this case, since the resistance value of the resistance element 41 can be easily changed compared to a case where the resistance element 41 is provided inside the transmission driver IC 10, fine adjustment in impedance matching can be facilitated (the same applies to the resistance element 42). The resistance element 43 may be provided outside the transmission driver IC 20. As a result, since a resistance value of the resistance element 43 can be easily changed compared to a case where the resistance element 43 is provided inside the transmission driver IC 20, fine adjustment in impedance matching can be facilitated (the same applies to the resistance element 44).

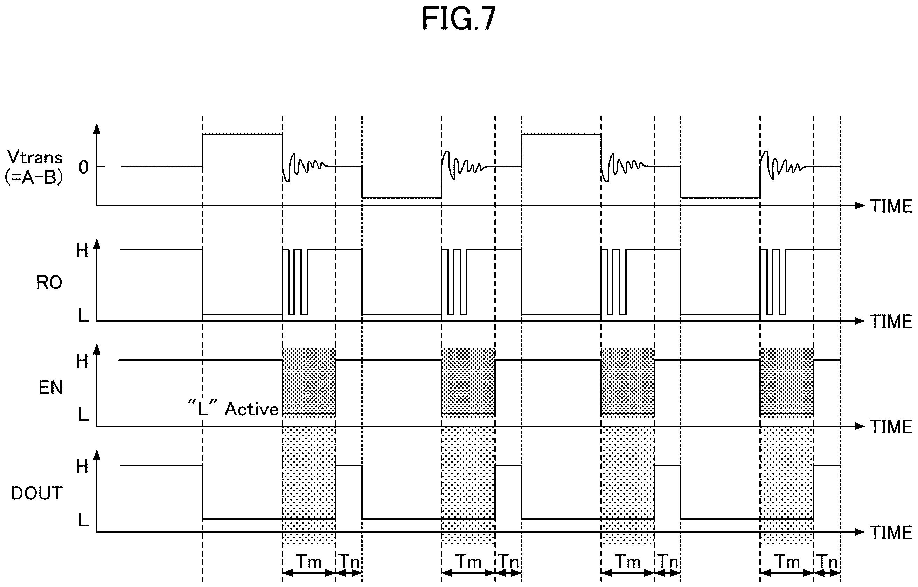

FIG. 7 is a timing chart for describing an example of the configuration and method in which the transmission driver ICs control the bypass circuits according to the first embodiment. The control circuit 14 supplies excess communication line current Itrans into the bypass circuits 13A and 13B, by using, as a trigger, a change in the internal signal RO according to a change from ON to OFF of the differential signal (in this example, the AMI signal) that is transmitted via the communication lines A and B. Similarly, the control circuit 24 supplies excess communication line current Itrans into the bypass circuits 23A and 23B by using, as a trigger, a change in the internal signal RO according to the change from ON to OFF of the differential signal (in this example, the AMI signal) that is transmitted via the communication lines A and B. In a case of FIG. 7, the change from ON to OFF of the AMI signal is caused by a falling edge where the level of the voltage Vtrans falls from 1 to 0, or a rising edge where the level of voltage Vtrans rises from -1 to 0.

As shown in FIG. 7, the internal signal RO may also exhibit ringing in response to the ringing behavior of the waveform of the AMI signal waveform. In this case, if the control circuits 14 and 24 each activate the enable signal EN by using, as a trigger, the change in the internal signal RO according to the change from ON to OFF of the AMI signal (in the case of Fig. 7, a rising edge), the enable signal EN may become unstable. This is because the ringing of the internal signal RO occurs immediately after a trigger timing.

In the case of FIG. 7, when the control circuits 14 and 24 each detect the change in the internal signal RO according to the change from ON to OFF of the AMI signal (in the case of Fig. 7, the rising edge), these control circuits latch the enable signals EN. In this arrangement, even if the internal signal RO becomes unstable, the enable signal EN remains active. By releasing the latch of the enable signal EN after the the first half period Tm expires, the control circuits 14 and 24 can each deactivate the enable signal EN during the second half period Tn.

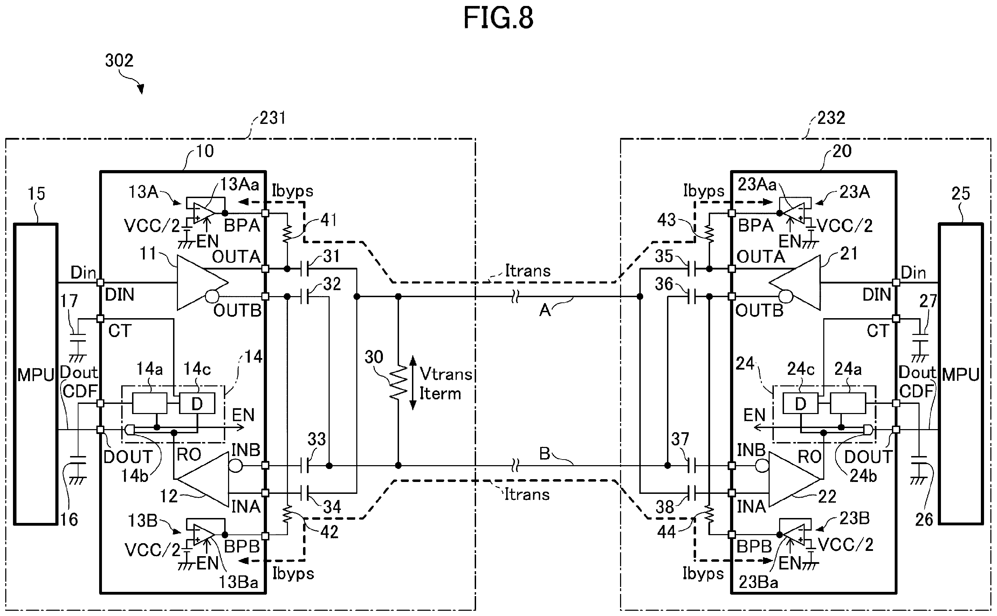

FIG. 8 is a diagram illustrating a bus system including transmission driver ICs according to a second embodiment. In a bus system 302 according to the second embodiment, description of the same configuration, operation, and effect as in the bus system 301 according to the first embodiment will be omitted by referring to the above description. The control circuits 14 and 24 of the transmission driver ICs 10 and 20 according to the second embodiment differ from the control circuits 14 and 24 of the transmission driver ICs 10 and 20 according to the first embodiment, by further including delay circuits 14c and 24c that generate respective delay times D.

The delay circuit 14c may generate the delay time D according to a charging time for a capacitor 17, which is connected via a connection terminal CT of the transmission driver IC 10, to reach a predetermined second voltage. The signal generation circuit 14a changes the enable signal EN from inactive to active after the delay time D has expired from an edge of the internal signal RO. The delay circuit 24c may generate the delay time D according to a charging time for a capacitor 27, which is connected via a connection terminal CT of the transmission driver IC 20, to reach a predetermined second voltage. The signal generation circuit 24a changes the enable signal EN from inactive to active after the delay time D has expired from an edge of the internal signal RO.

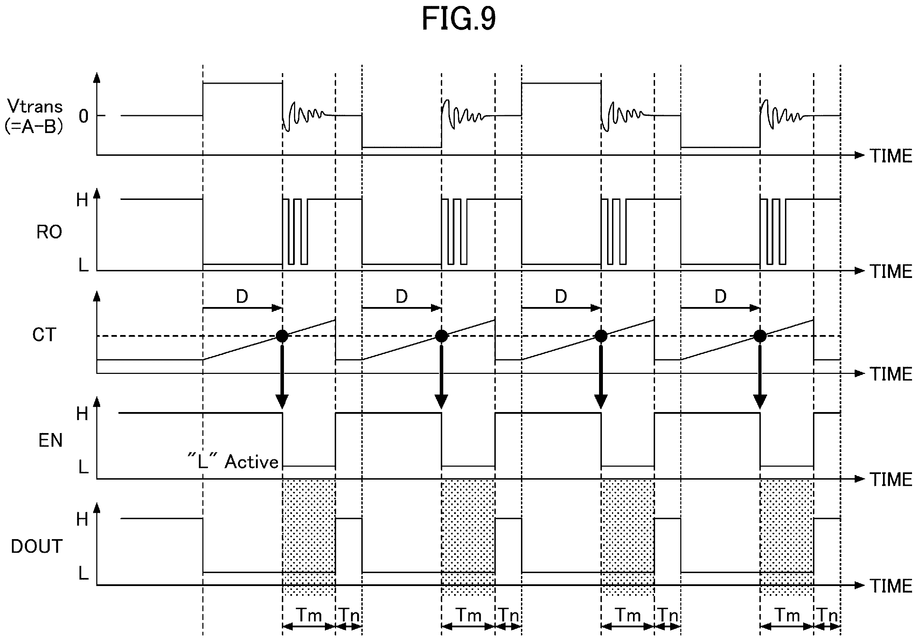

FIG. 9 is a timing chart for describing an example of the configuration and method in which transmission driver ICs control bypass circuits according to the second embodiment. After the delay time D expires, the control circuit 14 supplies excess communication line current Itrans into the bypass circuits 13A and 13B, by using a change in the internal signal RO according to a change from OFF to ON of the differential signal (in this example, the AMI signal) that is transmitted via the communication lines A and B. Similarly, after the the delay time D expires, the control circuit 24 supplies excess communication line current Itrans into the bypass circuits 23A and 23B by using, as a trigger, a change in the internal signal RO according to the change from OFF to ON of the differential signal (in this example, the AMI signal) that is transmitted via the communication lines A and B. In a case of FIG. 9, the change from OFF to ON of the AMI signal is caused by a rising edge where the level of the voltage Vtrans rises from 0 to 1, and a falling edge where the level of voltage Vtrans falls from 0 to -1.

As shown in FIG. 9, there is a case where the internal signal RO also exhibits ringing in response to the ringing behavior of the AMI signal waveform. In this case, if the control circuits 14 and 24 each activate the enable signal EN by using, as a trigger, a change in the internal signal RO according to a change from ON to OFF of the AMI signal (in the case of Fig. 7, a rising edge), the enable signal EN may become unstable. This is because the ringing of the internal signal RO occurs immediately after a trigger timing.

In the case of FIG. 9, when the control circuits 14 and 24 each detect the change in the internal signal RO according to the change from OFF to ON of the AMI signal (in the case of Fig. 7, a falling edge), the enable signal EN can be kept inactive until the delay time D expires, and the enable signal EN can be changed to active after the delay time D expires. The signal generation circuit 14a may determine a time for making the enable signal EN active according to a charging time for the capacitor 16 connected via the connection terminal CDF of the transmission driver IC 10 to reach a predetermined first voltage. In this arrangement, even if the internal signal RO becomes unstable, the enable signal EN remains active. The control circuits 14 and 24 each deactivate the enable signal EN after the first half period Tm expires.

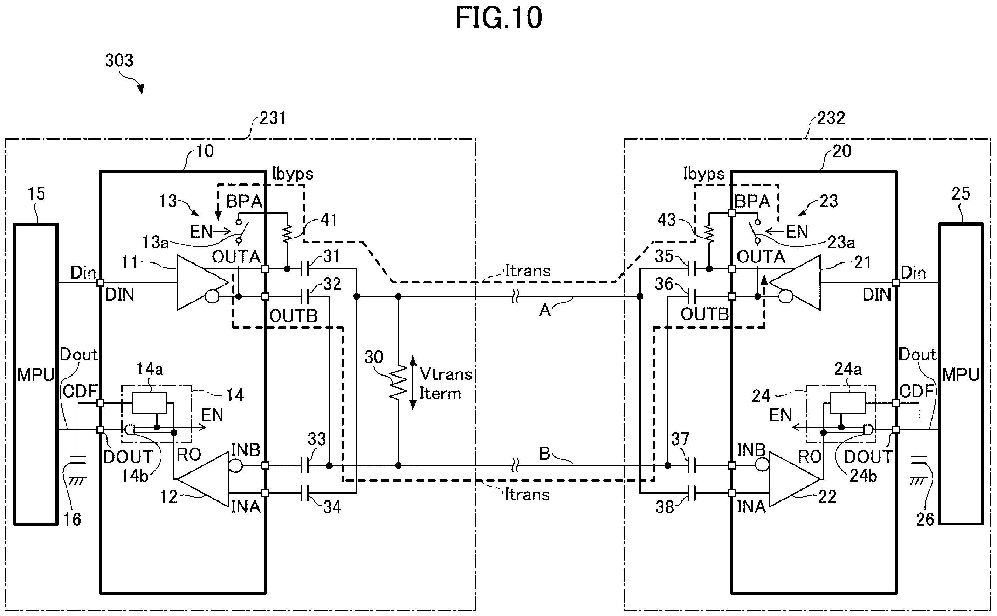

FIG. 10 is a diagram illustrating a bus system including transmission driver ICs according to a third embodiment. In a bus system 303 according to the third embodiment, description of the same configuration, operation and effect as in the bus system 301 according to the first embodiment will be omitted by referring to the above description. The bypass circuits 13 and 23 of the transmission driver ICs 10 and 20 according to the third embodiment differ from the bypass circuits of the transmission driver ICs 10 and 20 according to the first embodiment, by including respective switches 13a and 23a for electrically connecting the communication line A and the communication line B.

In this example, the enable signal EN generated by the control circuit 14 is input to the switch 13a, and the enable signal EN generated by the control circuit 24 is input to the switch 23a. The switches 13a and 23a electrically connect (turn on) the communication line A and the communication line B when the enable signal EN is active, and cut off (turn off) an electrical connection between the communication line A and the communication line B when the enable signal EN is inactive. As shown in FIG. 6, by turning on the switches 13a and 23a, the excess current Iterm flowing into the termination resistor 30 is reduced, and thus the excess voltage Vtrans generated across the ends of the termination resistor 30 is reduced. As a result, since the distortion of the communication waveform propagated by the pair of communication lines A and B is suppressed, occurrence of communication failure is reduced.

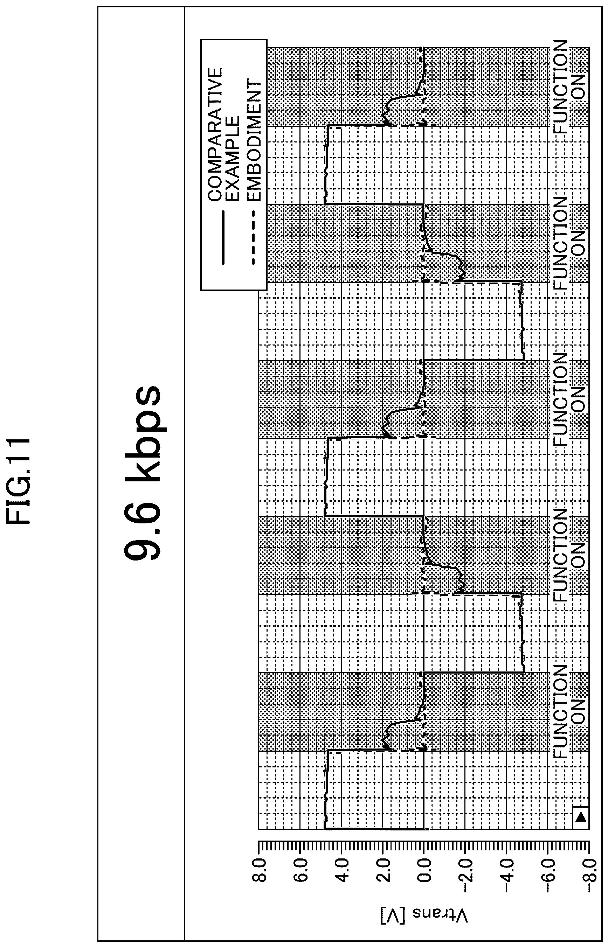

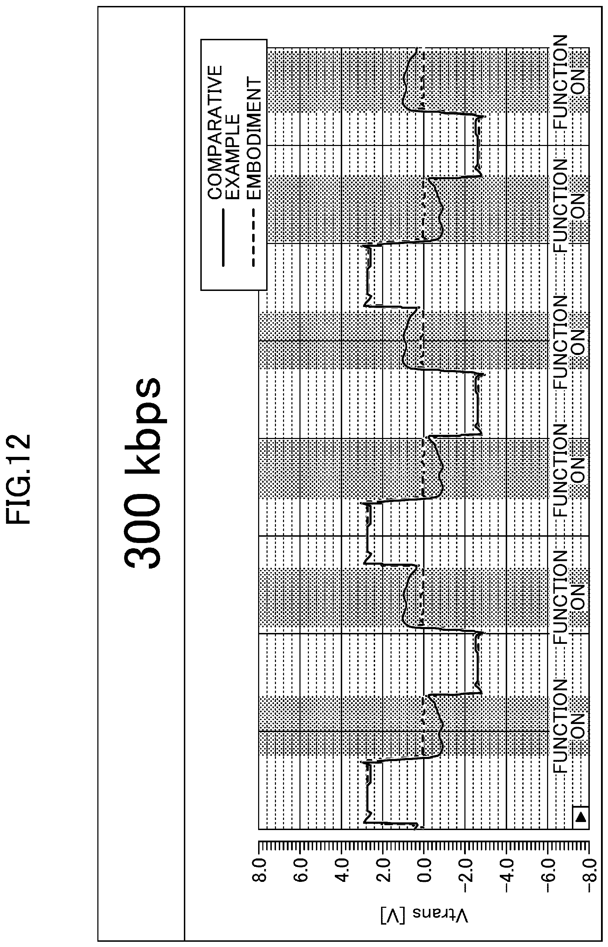

FIG. 11 is a diagram showing an example of the effect of suppressing the waveform distortion of the AMI signal at a communication speed of 9.6 kbps. FIG. 12 is a diagram showing an example of the effect of suppressing the waveform distortion of the AMI signal at a communication speed of 300 kbps. In the legends of FIGS. 11 and 12, a comparative example represents the first comparative example shown in FIG. 3, and the embodiment represents the first embodiment shown in FIG. 5. As shown in FIGS. 11 and 12, by using the internal signal RO as a trigger to flow the current through the bypass circuit, distortion of the communication waveform can be suppressed, and the communication speed can be increased.

Although the embodiments have been described above, the above embodiments are presented as examples, and the present invention is not limited to the above embodiments. These embodiments can be implemented in various other forms, and various combinations, omissions, substitutions, and changes can be made without departing from the gist of the invention. These embodiments and variations thereof are included within the scope and gist of the invention, as well as within the scope of equivalents of the invention and the claims.

For example, the communication system may be different from the AMI system.

The device provided with the transmission driver IC is not limited to an air-conditioning device, and may be other device such as a telephone device, a security device, an audio device, a video device, or a communication device.

## Claims

1. A bus system comprising:
a first transmission driver IC;
a second transmission driver IC;
a first communication line and a second communication line that couple the first transmission driver IC and the second transmission driver IC; and
a termination resistor coupled between the first communication line and the second communication line,
wherein each of the first transmission driver IC and the second transmission driver IC includes:
a transmission circuit configured to transmit a differential signal to the first communication line and the second communication line,
a reception circuit configured to convert the differential signal that is received from the first communication line and the second communication line to an internal signal,
a bypass circuit coupled to the first communication line or the second communication line, and
a control circuit configured to operate the bypass circuit using the internal signal as a trigger such that a communication line current flowing into the first communication line or the second communication line flows into the bypass circuit.

2. The bus system according to claim 1, wherein the control circuit is configured to supply the communication line current into the bypass circuit during an off period of the differential signal.

3. The bus system according to claim 2, wherein the control circuit is configured to:
supply the communication line current into the bypass circuit during a first half period of the off period, and
stop the communication line current from flowing into the bypass circuit during a second half period of the off period.

4. The bus system according to claim 3, wherein the control circuit is configured to:
mask an external output of the internal signal during the first half period, and
cancel the masking of the external output during the second half period.

5. The bus system according to claim 2, wherein the control circuit is configured to supply the communication line current into the bypass circuit by using, as a trigger, a change in the internal signal according to a change of the differential signal from ON to OFF.

6. The bus system according to claim 2, wherein the control circuit includes a delay circuit configured to generate a delay time, and
wherein after the delay time expires, the control circuit is configured to supply the communication line current into the bypass circuit by using, as a trigger, a change in the internal signal according to a change of the differential signal from OFF to ON.

7. The bus system according to claim 1, wherein the bypass circuit has an impedance lower than that of the termination resistor.

8. The bus system according to claim 7, wherein the bypass circuit has a resistance element having a resistance value lower than that of the termination resistor.

9. The bus system according to claim 8, wherein the resistance element is provided outside the first transmission driver IC or the second transmission driver IC.

10. The bus system according to claim 1, wherein the bypass circuit has current sinking capability and current sourcing capability.

11. The bus system according to claim 1, wherein the bypass circuit includes a switch configured to form an electrical connection between the first communication line and the second communication line.

12. A transmission driver IC comprising:
a transmission circuit configured to transmit a differential signal to a first communication line and a second communication line between which a termination resistor is interposed;
a reception circuit configured to convert the differential signal that is received from the first communication line and the second communication line to an internal signal;
a bypass circuit; and
a control circuit configured to operate the bypass circuit using the internal signal as a trigger such that a communication line current flowing into the first communication line or the second communication line flows into the bypass circuit, which is coupled to the first communication line or the second communication line.

13. The transmission driver IC according to claim 12, further comprising:
a plurality of terminals including a first transmit terminal, a second transmit terminal, a first receive terminal, and a second receive terminal,
wherein the transmission circuit is configured to transmit the differential signal to the first communication line and the second communication line via the first transmit terminal and the second transmit terminal, and
wherein the reception circuit is configured to receive the differential signal from the first communication line and the second communication line via the first receive terminal and the second transmit terminal.

14. A device comprising:
an input/output circuit configured to output a transmission signal and receive a reception signal; and
a transmission driver IC including:
a transmission circuit configured to convert the transmission signal to a differential signal to be transmitted to a first communication line and a second communication line between which a termination resistor is interposed,
a reception circuit configured to convert the differential signal that is received from the first communication line and the second communication line to an internal signal,
a bypass circuit, and
a control circuit configured to operate the bypass circuit by using the internal signal as a trigger such that a communication line current flowing into the first communication line or the second communication line flows into the bypass circuit, which is coupled to the first communication line or the second communication line.
